# EUROPEAN PATENT APPLICATION

(11) **EP 0 712 167 A2**
(43) Date of publication of application: **15.05.1996**
(21) Application number: 95117710.4
(22) Date of filing: 09.11.1995
(51) Int. Cl.: H01L 29/872

(54) **Schottky barrier diode**

(30) Priority: 11.11.1994 JP 278035/94
(71) Applicant: MURATA MANUFACTURING CO., LTD., Nagaokakyo-shi Kyoto-fu 226 (JP)
(72) Inventor: Miyata, Tomoyasu, c/o Murata Manufacturing Co, Ltd, Nagaokakyo-shi, Kyoto-fu (JP); Sakamoto, Koichi, c/o Murata Manufacturing Co, Ltd, Nagaokakyo-shi, Kyoto-fu (JP); Toyama, Katsutoshi, Urazoe-shi, Okinawa-ken (JP); Sueyoshi, Masaaki, c/o Murata Manuf Co, Ltd, Nagaokakyo-shi, Kyoto-fu (JP)
(74) Representative: Laufhütte, Dieter, Dr.-Ing.

(57) **Abstract**

There is provided a Schottky barrier diode wherein concentration of an electrical field at an edge of an insulation layer is suppressed to improve the reverse breakdown voltage.

An n⁻ layer of a compound semiconductor substrate constituted by an n⁺ layer and the n⁻ layer is configured in the form of a mesa. An insulation layer is formed on at least a skirt portion and a slant portion of the mesa. An anode is formed on the insulation layer and n⁻ layer, and a cathode is formed on the n⁺ layer. Thus, concentration of an electrical field at an edge of the insulation layer is canceled by an electrical field generated at the anode on the slant portion to improve the reverse breakdown voltage.

## Description

### BACKGROUND OF THE INVENTION

1. Field of the Invention
   The present invention relates to a Schottky barrier diode wherein the reverse breakdown voltage is improved by forming the compound semiconductor substrate in the form of a mesa to cancel a fringing component in an electrical field that concentrates at an edge of an insulation layer by an electrical field of an anode formed at a slant portion of the mesa. The present invention further relates to a semiconductor device and a method of improving reverse breakdown voltage in a Schottky barrier diode.
2. Description of the Related Art
   As shown in Fig. 5, conventional Schottky diodes have a structure wherein a cathode 12 is formed on an n⁺ layer 11a of a GaAs substrate and an anode 13 is formed on an n⁻ layer 11b of the GaAs substrate. However, when a reverse bias voltage is applied to Schottky barrier diodes having such a conventional structure, a fringing effect of an electrical field causes concentration of an electrical field at an edge 14 of the anode 13. As a result, a breakdown can be caused at a low reverse bias voltage. In order to suppress such concentration of an electrical field, according to an improvement in the prior art, an insulation layer 15 such as a nitride film is interposed between the n⁻ layer 11b and the anode 13 at a peripheral portion of the GaAs substrate, as shown in Fig. 6 to improve the peak inverse voltage.
   Although the conventional improved Schottky barrier diode shown in Fig. 6 has a reverse breakdown voltage that is somewhat better than that of the conventional Schottky barrier diode before the improvement shown in Fig. 5, the reverse breakdown voltage is still insufficient because a fringing component in the concentrated electrical field can not be sufficiently suppressed at an edge 16 of an insulation layer 15.
   It is therefore an object of the present invention to provide a Schottky barrier diode, a semiconductor device and a method of improving reverse breakdown voltage in a Schottky barrier diode wherein concentration of an electrical field at an edge of the insulation layer is suppressed to improve the peak inverse voltage.

### SUMMARY OF THE INVENTION

The present invention solves the above-described problem by providing a Schottky barrier diode including a compound semiconductor substrate constituted by an n⁺ layer and an n⁻ layer which is configured in the form of a mesa, an insulation layer formed on at least a skirt portion and a slant portion of the mesa, an anode formed on the n⁻ layer and the insulation layer, and a cathode formed on the n⁺ layer. According to a preferred embodiment, an electrical field that concentrates at an edge of the insulation layer is canceled at least in part by an electrical field generated at the anode on the slant portion to improve the reverse breakdown voltage.

The present invention solves the above-described problem further by providing a semiconductor device according to claim 3. Preferred embodiments are described in subclaims 4 to 11.

The present invention solves the above-described problem further by providing a method according to claim 12. Preferred embodiments are described in subclaims 13 to 18.

According to the present invention, an n⁻ layer of a compound semiconductor substrate is configured in the form of a mesa; an insulation layer is formed on at least a skirt portion and a slant portion of the mesa; and an anode is formed on the insulation layer and n⁻ layer. As a result, an electrical field that concentrates at an edge of the insulation layer is canceled by an electrical field generated at the anode on the slant portion to improve the peak inverse voltage.

### BRIEF DESCRIPTION OF THE DRAWINGS

- Fig. 1: shows a configuration of a first embodiment of the present invention.
- Fig. 2: illustrates a mechanism for suppressing concentration of an electrical field.
- Fig. 3: shows a configuration of a second embodiment of the present invention.
- Fig. 4: shows a configuration of a third embodiment of the present invention.
- Fig. 5: shows a conventional configuration.
- Fig. 6: shows another conventional configuration.

### DETAILED DESCRIPTION OF THE PREFERRED EMBODIMENTS

Preferred embodiments of the present invention will now be described with reference to the accompanying drawings.

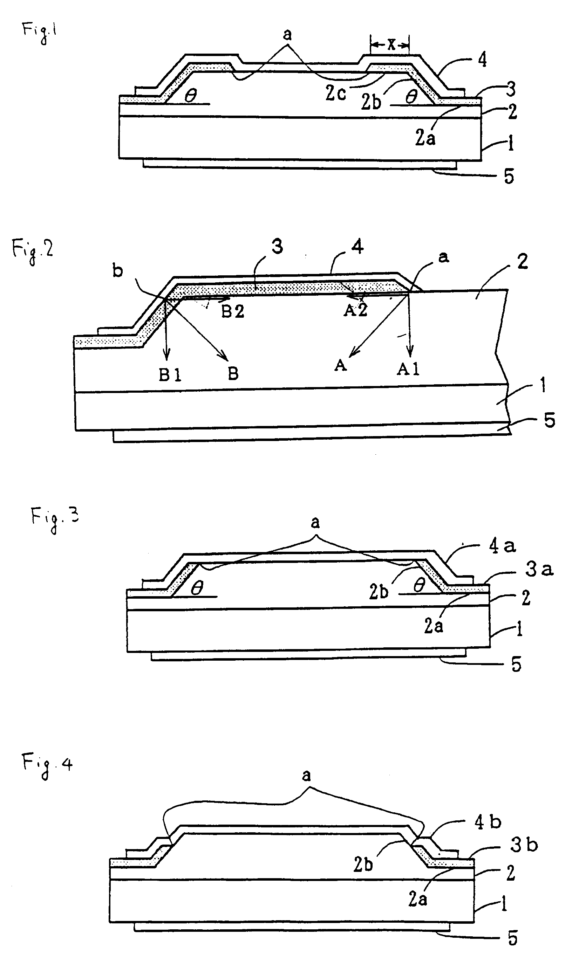

Fig. 1 shows a first embodiment of the present invention. In Fig. 1, reference numeral 1 designates an n⁺ layer of GaAs substrate, and reference numeral 2 designates an n⁻ layer of the GaAs substrate. The n⁻ layer 2 of the GaAs substrate is configured in the form of a mesa, so as to have a top portion, a side face referred to as a slant portion 2b, and a lower portion referred to as a skirt portion 2a. An insulation layer 3 such as a nitride film is formed on a skirt portion 2a, a slant portion 2b, and a top peripheral portion 2c of the mesa. The slant portion 2b is formed to have an inclination ⊖ in the range from 10 to 90 deg. An anode 4 is formed on the central portion of the top of the n⁻ layer 2 and on the insulation layer 3. Further, a cathode 5 is formed on the underside of the n⁺ layer 1 of the GaAs substrate.

The present embodiment has the configuration as described above. A description will now be made on a method for manufacturing the present embodiment. Wet etching is performed to form the n⁻ layer 2 of the GaAs substrate in the form of a mesa. Thereafter, an insulation layer 3 such as a nitride film is formed on the mesa-shaped n⁻ layer 2 of the GaAs substrate, and the insulation layer 3 is removed at the center of the n⁻ layer 2 of the GaAs substrate by means of wet etching to provide an opening. Then, the anode 4 and cathode 5 are formed using vapor deposition.

A description will now be made with reference to Fig. 2 on a mechanism for suppressing a fringing component in an electrical field that concentrates at an edge a of the insulation layer 3 according to the present embodiment. When a reverse bias voltage is applied, the direction of the electrical field at the edge a of the insulation layer 3 becomes perpendicular to the anode 4 as indicated by a vector A. The electrical field indicated by the vector A is divided into a vertical component A1 and a horizontal component A2. The horizontal component A2 is a fringing component of the electrical field that concentrates on the edge a. On the other hand, since the direction of an electrical field at a slant point b of the anode 4 is perpendicular to the anode 4 as indicated by a vector B. The electrical field indicated by the vector B is divided into a vertical component B1 and a horizontal component B2. Then, the directions of the horizontal component (fringing component) A2 of the electrical field at the edge a and the horizontal component B2 of the electrical field at the slant point b are opposite to each other. Therefore, the horizontal component (fringing component) A2 of the electrical field at the edge a is canceled and suppressed by the electrical field generated at the slant point b of the mesa. This improves the reverse breakdown voltage at the edge a.

A second embodiment of the present invention will now be described with reference to Fig. 3. The shape of the mesa in the present embodiment is substantially the same as that in the first embodiment shown in Fig. 1. Therefore, parts identical to those in the first embodiment are indicated by the same reference numerals as in the first embodiment. The present embodiment is different from the first embodiment primarily in the shape of an insulation layer 3a. The insulation layer 3a having a shape different from the first embodiment is formed by changing the time for the etching of the insulation layer as described with reference to the first embodiment. Especially, the insulation layer 3a covers the slant portion 2b perfectly and the top of the mesa and the edge of the insulation layer 3a are flatly formed. Such a flat structure may be formed by removing the insulation layer on the top of the mesa by means of RIE (reactive ion etching) using a resist pattern such as spin on glass (SOG). In the present embodiment, the insulation layer 3a is formed on the slant portion 2b and skirt portion 2a of the mesa, and an anode 4a is formed on the top of the mesa and the insulation layer 3a.

According to the present embodiment, concentration of an electrical field occurs at an edge a of the insulation layer 3 as in the first embodiment. An electrical field generated by the anode 4a formed on the insulation layer 3a on the slant portion 2b of the mesa acts on the electrical field that concentrates at the edge a to suppress a fringing component in the concentrated electrical field like the mechanism illustrated in Fig. 2. Thus, the reverse breakdown voltage is improved.

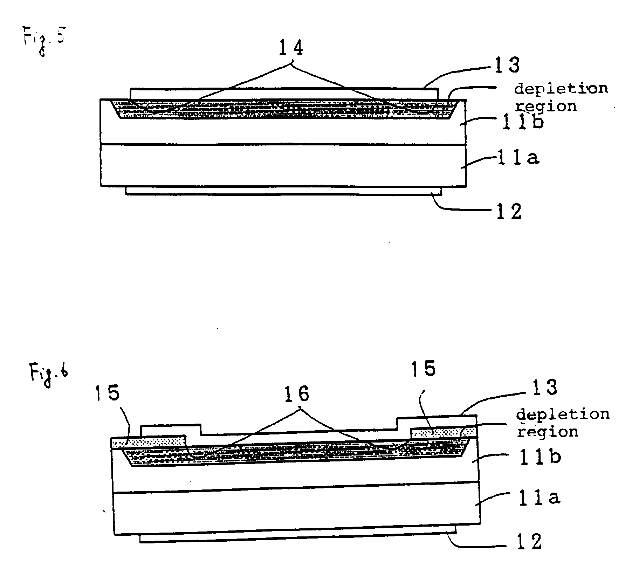

A third embodiment of the present invention will now be described with reference to Fig. 4. The shape of the mesa in the present embodiment is substantially the same as that in the first embodiment shown in Fig. 1. Therefore, parts identical to those in the first embodiment are indicated by the same reference numerals as in the first embodiment. This third embodiment is different from the first embodiment primarily in the shape of an insulation layer 3b. The insulation layer 3b having a shape different from the first embodiment is formed by changing the time for the etching of the insulation layer as described with reference to the first embodiment.

In the present embodiment, the insulation layer 3b is formed on a lower part of the slant portion 2b and on the skirt portion 2a of the mesa, and an anode 4b is formed on the top of the mesa, an upper part of the slant portion 2b, and an insulation layer 3b.

According to the present embodiment, concentration of an electrical field occurs at an edge a of the insulation layer 3 as in the first embodiment. An electrical field generated by the anode 4b formed directly on the upper part of the n⁻ layer 2 of the GaAs substrate at the slant portion 2b of the mesa acts on the electrical field that concentrates at the edge a to suppress a fringing component in the concentrated electrical field like the mechanism illustrated in Fig. 2. Thus, the peak inverse voltage is improved.

A more specific embodiment will now be described. A GaAs substrate has been chosen to satisfy the conditions as shown below, and a reverse breakdown voltage has been measured as shown below for each of the configurations of the insulation layer and anode as illustrated in the drawings for the preferred embodiments and the prior art. The measurement obtained on the conventional configuration is shown for reference. The reverse breakdown voltages are values obtained at a leak current of 0.5 mA.

| [Conditions for the GaAs Substrate] | |
|---|---|
| Area of Anode | 0.4 X 0.4 mm² |
| Depth of Mesa (Height of Substrate at the Slant Portion) | 0.3 - 1.5 µm |
| Thickness of GaAs Substrate | 200 µm |
| Thickness of n⁻ layer | 9.7 µm |
| Carrier Density of n⁻ layer | 2.26 X 10¹⁵cm⁻³ |

| [Measured Peak Inverse Voltage] | |
|---|---|
| Conventional Configuration shown in Fig. 6 | 88.2 V |
| First Embodiment Shown in Fig. 1 | 95.7 V |
| Second Embodiment Shown in Fig. 3 | 101.0 V |
| Third Embodiment Shown in Fig. 4 | 106.4 V |

The first embodiment shown in Fig. 1 provides a significant effect when the width of the intersection x is 3 µm or less. In other words, it is preferable that the insulation layer 2c covers a part of the top face of the mesa which locates within 3 µm or less from the edge of the top face.

According to the present invention, an n⁻ layer of a compound semiconductor substrate is configured in the form of a mesa; an insulation layer is formed on at least a skirt portion and a slant portion of the mesa; and an anode is formed on the insulation layer and n⁻ layer. As a result, an electrical field that concentrates at an edge of the insulation layer is canceled by an electrical field generated at the anode on the slant portion to improve the reverse breakdown voltage.

The improved reverse breakdown voltage results in improved reliability. If a peak inverse voltage at a level available in the prior art is required, characteristics in the forward direction can be improved by increasing the carrier densitiy of the n⁻ layer or by reducing the thickness of the n⁻ layer.

The above-described effects make it possible to reduce the area of an anode, which leads to a reduction in the size of a chip. Such a reduction in chip size allows the number of chips obtained from one sheet of wafer to be increased, and this results in a cost reduction.

While specific illustrated embodiments have been shown and described, it will be appreciated by those skilled in the art that various modifications, changes and additions can be made to the invention without departing from the spirit and scope thereof as set forth in the following claims.

## Claims

1. A Schottky barrier diode comprising:
a compound semiconductor substrate having an n⁺ layer and an n⁻ layer which is configured in the form of a mesa;
an insulation layer formed on at least a skirt portion and a slant portion of the mesa;
an anode formed on the insulation layer and n⁻ layer; and
a cathode formed on the n⁺ layer.

2. A Schottky barrier diode as claimed in claim 1, wherein an electrical field that concentrates at an edge of the insulation layer is canceled at least in part by an electrical field generated at the anode on the slant portion to improve the reverse breakdown voltage of the Schottky barrier diode.

3. A semiconductor device comprising:
a semiconductor substrate having an active layer which is configured in the form of a mesa;
an insulation layer formed on at least a skirt portion and a slant portion of the mesa;
an anode formed on the insulation layer and the active layer; and
a cathode formed on the substrate opposite the anode.

4. A semiconductor device as claimed in claim 3, wherein said semiconductor device is a Schottky barrier diode, said active layer being an n⁻ layer, said substrate being a compound substrate having said n⁻ layer and an n⁺ layer, and said cathode being formed on said n⁺ layer.

5. A semiconductor device as claimed in claim 3 or 4, wherein an electrical field that concentrates at an edge of the insulation layer is canceled at least in part by an electrical field generated at the anode on the slant portion to improve the reverse breakdown voltage of the semiconductor device.

6. A semiconductor device as claimed in claim 4 or 5, wherein said skirt portion of said n⁻ layer is generally horizontal, said slant portion defines an angle with said skirt portion, and extends upward to a top surface of said mesa.

7. A semiconductor device as claimed in claim 6, wherein said angle is about 10-90 degrees.

8. A semiconductor device as claimed in claim 6 or 7, wherein said insulation layer covers the entire slant portion of the mesa.

9. A semiconductor device as claimed in claim 8, wherein said insulation layer further extends onto a portion of said top surface of said mesa.

10. A semiconductor device as claimed in claim 9, wherein said insulation layer extends about 3µm or less onto said top surface of said mesa.

11. A semiconductor device as claimed in any one of claims 3 to 10, wherein said insulation layer covers only part of said slant portion of the mesa.

12. A method of improving reverse breakdown voltage in a Schottky barrier diode comprising a compound semiconductor substrate having an n⁺ layer and an n⁻ layer, an insulation layer on the n⁻ layer, an anode formed on the insulation layer and on the n⁻ layer, and a cathode formed on the n⁺ layer, the method comprising the steps of:
configuring the n⁻ layer in the form of a mesa; and
forming the insulation layer on at least a skirt portion and a slant portion of the mesa, whereby an electrical field that concentrates at an edge of the insulation layer is canceled at least in part by an electrical field generated at the anode on the slant portion to thereby improve the reverse breakdown voltage of the Schottky barrier diode.

13. A method as claimed in claim 12, wherein the skirt portion of the n⁻ layer is generally horizontal, the slant portion defines an angle with the skirt portion, and the slant portion extends upward to a top surface of the mesa.

14. A method as claimed in claim 12 or 13, wherein the angle is about 10-90 degrees.

15. A method as claimed in any one of claims 12 to 14, wherein the insulation layer is formed on the entire slant portion of the mesa.

16. A method as claimed in claim 15, wherein the insulation layer is further formed on a portion of the top surface of the mesa.

17. A method as claimed in claim 16, wherein the insulation layer is formed to extend about 3µm or less onto the top surface of the mesa.

18. A method as claimed in any one of claims 12 to 17, wherein the insulation layer is formed on part but not all of the slant portion of the mesa.
